Europäisches Patentamt

European Patent Office

Office européen des brevets

(11) Veröffentlichungsnummer: **0 476 336 A2**

## (12) EUROPÄISCHE PATENTANMELDUNG

(21) Anmeldenummer: **91113968.1**

(22) Anmeldetag: **21.08.91**

(51) Int. Cl.5: **C30B 29/04**, C30B 25/02

(30) Priorität: **31.08.90 DE 4027580**

(43) Veröffentlichungstag der Anmeldung:
**25.03.92 Patentblatt 92/13**

(84) Benannte Vertragsstaaten:
**AT BE CH DE DK ES FR GB GR IT LI LU NL SE**

(71) Anmelder: **Lux, Benno, Prof. Dr.**
**Brentsch-Park 85**
**CH-7550 Scuol/GR(CH)**

(72) Erfinder: **Lux, Benno, Prof. Dr.**
**Brentsch-Park 85**
**CH-7550 Scuol/GR(CH)**

(74) Vertreter: **Weber, Dieter, Dr. et al**
**Dr. Dieter Weber, Dipl.-Phys., Klaus Seiffert,**
**Dr. Winfried Lieke, Patentanwälte,**
**Gustav-Freytag-Strasse 25**
**W-6200 Wiesbaden 1(DE)**

(54) **Verbundkörper, Verfahren zu dessen Herstellung und dessen Verwendung.**

(57) Ein Verbundkörper mit verbesserter Wärmeleitfähigkeit, bestehend aus einem Substrat, dessen Oberflächenschicht ein homöo- oder heteroepitaktisches Wachstum des Diamantgitters aus der Gasphase ermöglicht, und einer auf dem Substrat aufgewachsenen Niederdruckdiamantschicht ist dadurch gekennzeichnet, daß die aufgewachsene Diamantschicht gegenüber der normalen Diamantzusammensetzung mit dem Kohlenstoffisotop $C^{12}$ angereichert und den schwereren Kohlenstoffisotopen $C^{13}$ und $C^{14}$ abgereichert ist. Bei der Herstellung eines solchen Verbundkörpers durch Aufwachsen einer Diamantschicht mit Hilfe der Niederdruckdiamantsynthese auf einem Substrat verwendet man während des Aufwachsens der Diamantschicht in der Gasphase ein mit dem Kohlenstoffisotop $C^{12}$ angereichertes und mit den schwereren Kohlenstoffisotopen $C^{13}$ und $C^{14}$ abgereichertes Gas. Die Verbundkörper werden zweckmäßig zur Wärmeableitung verwendet.

EP 0 476 336 A2

Die hohe Wärmeleitfähigkeit von Diamant wird technisch zur Ableitung von Wärme industriell verwendet, wobei relativ reine, einkristalline Naturdiamanten oder Hochdruckdiamanten verwendet werden. Da der Wärmetransport in Diamant, im Gegensatz zu den meisten metallischen Leitern, weniger durch die freien Elektronen als durch Phononen, d.h. gequantelte Gitterschwingungen, getragen wird (siehe W. Schatt, Einführung in die Werkstoffwissenschaft, Seite 422, VEB Deutscher Verlag für Grundstoffindustrie, Leipzig 1981), wurde aufgrund theoretischer Überlegungen seit langem vorhergesagt, daß die Wärmeleitfähigkeit in einem isotopenreinen Diamantkristallgitter wesentlich höher sein müßte als in normalen Diamanten, die aus mehreren Kohlenstoffisotopen ($C^{12}$, $C^{13}$, $C^{14}$) bestehen. Diese theoretische Überlegung wurde durch die Herstellung eines relativ reinen $C^{12}$-Diamanteinkristalles mit Hilfe der Hochdruckdiamantsynthese bestätigt (siehe Science, Research News, 6. Juli 1990, Seiten 27/28 und NZZ-Forschung und Technik, Nr. 180, Seite 35,8. August 1990 und T. Anthony, NATO Summer School, Castel Vecchio, Italy, Juli 1990).

In mit dem Kohlenstoffisotop $C^{12}$ angereicherten einkristallinen Hochdruckdiamanten wurden Wärmeleitfähigkeiten bei Raumtemperatur gemessen, die etwa dem zehnfachen Wert von reinem Kupfer entsprechen. Es konnte gezeigt werden, daß eine Verringerung der Kohlenstoffisotopen $C^{13}$ und $C^{14}$ gegenüber der normalen Isotopenverteilung im Diamanten von etwa 1 % auf 0,5 % bereits zu einer deutlichen Erhöhung der Wärmeleitfähigkeit führte. Doch tritt dieser Effekt nur in einem relativ fehlerfreien Einkristallgitter auf, da Fehler im Kristallgitter eine ungestörte Phononenschwingung genauso negativ beeinflussen wie ungleiche Atommassen.

Die Niederdruckdiamantsynthese ermöglicht durch Verwendung von mit dem Kohlenstoffisotop $C^{12}$ angereicherten Gasen als Ausgangsmaterial die Herstellung solchermaßen angereicherter Diamantschichten. Allerdings führt diese Synthese normalerweise zu polykristallinen Diamantschichten, die viele Kristallgitterfehler aufweisen (siehe Ch. Chatfield et al, J. Mat. Science Letters, 1989), durch die die Wärmeleitfähigkeit so stark erniedrigt werden kann, daß auch in einem stark mit $C^{12}$ angereicherten Diamanten, der auf diese Weise hergestellt wurde, die Erhöhung der Wärmeleitfähigkeit gegenüber einem aus dem natürlichen Isotopengemisch aufgebauten Diamantgitter nicht wesentlich verbessert ist.

Es ist bisher nicht gelungen, die Niederdrucksynthese für die Herstellung von Diamanten zu verwenden, bei denen der Isotopeneffekt ausgenutzt werden kann. Vielmehr wird bis jetzt ein zweistufiges Verfahren angewendet (siehe Science, Research News, 6. Juli 1990, Seiten 27/28 und NZZ-Forschung und Technik, Nr. 180, Seite 35, August 1990). Bei diesem Verfahren wird zunächst mit der Niederdrucksynthese ein mit dem Isotop $C^{12}$ angereicherter Rohdiamant hergestellt, der dann in einem zweiten Verfahrensschritt im Hochdruckverfahren wieder völlig aufgelöst wird und erst dann unter hohem Druck zu einem Einkristall wächst. Diese Verfahrensweise ist kompliziert, aufwendig und teuer.

Die der Erfindung zugrundeliegende Aufgabe bestand nun darin, einen Diamanten mit verbesserter Wärmeleitfähigkeit zu bekommen, der unter Vermeidung des geschilderten zweistufigen Verfahrens einfacher herstellbar ist.

Erfindungsgemäß wird diese Aufgabe mit einem Verbundkörper mit verbesserter Wärmeleitfähigkeit gelöst, der aus einem Substrat, dessen Oberflächenschicht ein homöo- oder heteroepitaktisches Wachstum des Diamantgitters aus der Gasphase ermöglicht, und einer auf dem Substrat aufgewachsenen Niederdruckdiamantschicht besteht und dadurch gekennzeichnet ist, daß die aufgewachsene Niederdruckdiamantschicht gegenüber der normalen Diamantzusammensetzung mit dem Kohlenstoffisotop $C^{12}$ angereichert und den schwereren Kohlenstoffisotopen $C^{13}$ und $C^{14}$ abgereichert ist.

Ein solcher Verbundkörper kann in einem einstufigen Niederdrucksyntheseverfahren hergestellt werden, was eine erhebliche Bereicherung der Technik gegenüber dem aufwendigen oben geschilderten zweistufigen Verfahren ist.

Um zu gewährleisten, daß die auf dem Substrat aufgewachsene Niederdruckdiamantschicht nicht nur mit dem Kohlenstoffisotop $C^{12}$ angereichert ist, sondern auch von Kristallgitterfehlern so frei wie möglich ist, was den Effekt der verbesserten Wärmeleitfähigkeit weiter erhöht, ist es bevorzugt, daß das Substrat des Verbundkörpers entweder insgesamt aus einem Einkristall besteht oder eine einkristalline Oberflächenschicht besitzt.

Das insgesamt einkristalline Substrat bzw. die einkristalline Oberflächenschicht des Substrates, auf dem bzw. der die Niederdruckdiamantschicht aufgewachsen ist, kann beispielsweise aus nicht mit $C^{12}$ angereichertem einkristallinem Diamant, wie einem Naturdiamantkörper, einem Hochdruckdiamantkörper oder einem Niederdruckdiamantkörper oder einer Oberflächenschicht hieraus bestehen, wobei die Möglichkeit der Auswahl geeigneter und bevorzugter Kristallorientierungen, wie z.B. (100)/(110)/(111) besteht.

Stattdessen kann das einkristalline Substrat oder die einkristalline Oberflächenschicht des Substrates auch aus einem anderen Material bestehen, auf dessen Oberfläche unter den Bedingungen einer Niederdruckdiamantsynthese eine einkristalline Diamantbeschichtung heteroepitaktisch entsteht. Ein solches Material kann beispielsweise BN In einer seiner metastabilen, superharten Formen, BP, $C_3N_4$ oder ein Mischkristall, eine ternäre Phase oder ein Mischkörper aus einem oder mehreren der Elemente C, B, N, O, P und/oder S sein. Auch mit diesen Materialien können bevorzugte Kristallflächen ausgewählt werden.

Schließlich kann die einkristalline Oberflächenschicht des Substrates auch aus einer dünnen Schicht bis hin zu einer monomolekularen Schicht aus diamantartigem Kohlenstoff, amorphem Diamant oder einem anderen C-haltigen Körper bestehen, wie aus a:C oder a:CH oder kohlenstoffhaltigen Materialien mit dem räumlichen Aufbau der Adamanite.

Wesentlich ist, daß das Substrat oder dessen Oberflächenschicht geeignet ist, mit Hilfe der Niederdrucksynthese den mit $C^{12}$ angereicherten Diamanten unter Verwendung entsprechend mit $C^{12}$ angereicherten Gasen epitaxial, vorzugsweise in einkristalliner Form, aufwachsen zu lassen. Dies ist jedenfalls bei Substraten oder Substratoberflächenschichten möglich, die einkristalline Körper oder dünne einkristalline Schichten sind, deren Oberflächenatome durch ihre besondere geometrische Anordnung und chemische Bindung eine Keimbildung und homöo- oder heteroepitaktisches Wachstum des Diamantgitters aus der Gasphase ermöglichen. Das Substrat oder die Oberflächenschicht des Substrates kann aber auch aus einem monokristallinen Diamanten oder einem stengelkristallinen Diamanten bestehen. Wenn das Substrat oder die Substratoberflächenschicht aus Diamant besteht, ist es zweckmäßig, wenn dieser Diamant hohe Wärmeleitfähigkeit besitzt, was bedeutet, daß er hohe Reinheit hat.

Die auf dem Substrat aufgewachsene Niederdruckdiamantschicht braucht nicht notwendigerweise einkristallin zu sein, während sie erfindungsgemäß jedenfalls mit dem Kohlenstoffisotop $C^{12}$ angereichert sein muß. Diese mit $C^{12}$ angereicherte Niederdruckdiamantschicht kann erfindungsgemäß beispielsweise monokristallin oder stengelkristallin sein, wie erwähnt, ist sie aber bevorzugt einkristallin.

Für eine gute Verwendbarkeit zur Wärmeableitung ist es zweckmäßig, daß die aufgewachsene Niederdruckdiamantschicht das Substrat wenigstens teilweise bedeckt und größer als die Wärmequelle ist, deren Wärme abgeleitet werden soll, und daß die Niederdruckdiamantschicht eine Mindestdicke von 4 µm hat. Je dicker die Niederdruckdiamantschicht ist, desto besser ist die Wärmeableitung, doch ergeben sich aus Kostengründen Obergrenzen bezüglich der Schichtdicke.

Die Phononen-Wärmeleitung von Diamanten kann zu Schwierigkeiten beim Wärmeübergang an den Grenzflächen zwischen Diamant und Nichtdiamant führen. Dies kann beispielsweise dann eintreten, wenn eine Wärmeübertragung von dem Diamanten auf ein Metall erfolgen soll, da in den Metallen für die Wärmeleitung fast nur die leicht beweglichen Elektronen verantwortlich sind.

Um dieses Problem zu lösen, ist es erfindungsgemäß bevorzugt, wenn der Verbundkörper auf seiner Oberfläche und/oder unter seiner Niederdruckdiamantschicht eine zusätzliche Schicht eines anorganischen Stoffes aufweist, der eine Übertragung von Phononenimpulsen vom und zum Diamantgitter begünstigt. Eine solche zusätzliche Schicht wirkt als Wärmeübertragungsvermittler zu anderen Stoffen, wie Metallen. Zweckmäßig besteht eine solche zusätzliche Schicht aus einem anderen Superhartstoff oder aus einem Hartstoff aus der Gruppe der Carbide, Nitride, Boride, Phosphide, Sulfide, Aluminide, Oxide oder deren Mischkristallen oder aus intermetallischen Verbindungen und Phasen von Metallen und Metalloiden, in denen neben den Elektronen auch Phononen einen erheblichen Anteil an der Wärmeleitung übernehmen. Allgemeiner gesagt lassen sich für die zusätzliche Schicht für die Verbesserung der Übertragung von Phononenimpulsen anorganische Materialien verwenden, bei denen aufgrund der Art ihrer Atome (Größe und Gewicht) und aufgrund von deren räumlichen Anordnung eine solche Übertragung der Phononenimpulse (Energie) besonders günstig erfolgt. Solche zusätzlichen Schichten, die voll oder teilweise epitaktisch auf Diamantschichten aufwachsen können, lassen sich beispielsweise nach dem üblichen PVD-Verfahren, CVD-Verfahren oder durch Sputtern aufbringen.

Weiterhin ist es bevorzugt, wenn der Verbundkörper eine Oberflächenschicht besitzt, die die aufgewachsene Niederdruckdiamantschicht gegen Zerstörung oder Veränderung schützt. Eine solche Oberflächenschicht kann gleichzeitig die Eigenschaft haben, die Übertragung von Phononenimpulsen vom und zum Diamantgitter zu begünstigen, muß diese Eigenschaft aber nicht aufweisen. Auch diese Schicht kann nach dem PVD-Verfahren, CVD-Verfahren oder durch Sputtern aufgebracht werden. Sie kann den Diamant vor möglichen chemischen Reaktionen, wie chemischen Oberflächenangriff, Diffusion und katalytischer Beschleunigung der Diamantumwandlung in Graphit, schützen, wie beispielsweise gegen Zerstörung des ungeschützten Diamants durch Oxidation, die schon bei relativ niedrigen Temperaturen unter 500°C einsetzt.

Beispielsweise kann eine solche Schicht eine dünne Schicht aus Titancarbid oder Titannitrid oder Siliciumcarbid sein.

Das Substrat kann beispielsweise auch ein Werkzeug mit einer Oberflächenschicht, die das Aufwachsen der Niederdruckdiamantschicht zuläßt, sein.

Als Niederdrucksyntheseverfahren für das Aufwachsen der Diamantschicht auf dem Substrat kommen grundsätzlich alle Verfahren in Betracht, die ein Aufwachsen einer Diamantschicht nach der Niederdruckdiamantsynthese aus der Gasphase unter Anreicherung des Kohlenstoffisotops $C^{12}$ gestatten. Insbesondere kommen solche Verfahren in Betracht, die auf dem Substrat möglichst fehlerarme epitaxial gewachsene Diamantkristalle erzeugen können. In Betracht kommen Mikrowellenverfahren, Hot-Filament-Verfahren, Plasmaverfahren und chemische Flammenverfahren, gepulste und kontinuierliche Gleich- und Wechselstromentladungen, die bis in den lichtbogennahen Bereich geführt werden können, und diverse Kombinationsverfahren hiervon. Diese Verfahren sind an sich aus der Literatur bekannt, insbesondere für die Herstellung einkristalliner Halbleiter.

Die anzuwendenden Drücke liegen bei Mikrowellenverfahren, RF-Plasmaverfahren und RF-Flammenverfahren sowie bei DC/AC-Glow- Discharge-Verfahren und Hot-Filament-Verfahren zweckmäßig im Bereich von 0,1 bis 760, vorzugsweise im Bereich von 10 bis 200 Torr, bei Hot-Arc-Plasmaverfahren bei mindestens 10 Torr und vorzugsweise bei 300 bis 760 Torr und bei chemischen Flammenverfahren bei mindestens 10, vorzugsweise bei 500 bis 760 Torr.

Bei allen diesen Verfahren liegen die Gasdurchflußmengen zweckmäßig bei 1 bis 300 Liter, vorzugsweise bei 10 bis 100 Liter je Stunde, bezogen auf Normaldruck und typischerweise für kleine Laboratoriumsreaktoren mit einem Durchmesser von 3 bis 10 cm. Die Strömungsgeschwindigkeiten liegen typischerweise bei einigen Metern je Sekunde, sind aber stark abhängig von Gasdruck und Temperatur sowie der Reaktorgröße. Eine Substratkühlung kann bei allen genannten Verfahren zweckmäßig sein. Die Substrattemperatur liegt günstigerweise bei 350 bis 1200°C, vorzugsweise bei 600 bis 1050°C. Die Gasmischung besteht zweckmäßig aus Wasserstoff mit einer Kohlenstoffquelle, wie Methan oder anderen Kohlenwasserstoffen. Der Kohlenstoffanteil in der Gasmischung liegt zweckmäßig bei 0,01 bis 20 Vol.-%, vorzugsweise bei 0,5 bis 2 Vol.-%. Der Sauerstoffanteil, bezogen auf das Gesamtgasgemisch, liegt günstigerweise bei 0,01 bis 10, vorzugsweise bei 0,1 bis 1 Vol.-%. Statt des Sauerstoffzusatzes kann das Gasgemisch auch eine organische sauerstoffhaltige Verbindung, wie einen Alkohol, Aceton oder dergleichen enthalten, die gleichzeitig die Kohlenstoffquelle sein kann. Der Wasserstoff kann auch durch Fluor ersetzt werden. Beim chemischen Flammenverfahren verwendet man günstigerweise ein Gemisch von Kohlenwasserstoff mit reinem Sauerstoff, wobei als Kohlenwasserstoff beispielsweise Acetylen oder Methan verwendet werden. Bezüglich der Durchführung des Verfahrens wird auf die Literaturstelle "Proceedings 12. Int. Plansee-Seminar vom 8. bis 12. Mai 1989, Seiten 615 bis 631", hingewiesen.

Im allgemeinen führen besonders langsamere Wachstumsgeschwindigkeiten, hervorgerufen durch innerhalb gewisser Grenzen gehaltene niedrige Kohlenstoffkonzentrationen, niedrigen Gasdruck usw., verbunden mit geringen Sauerstoffgehalten, zum erwünschten Resultat.

Die erfindungsgemäßen Verbundkörper können mit großem Vorteil für unterschiedliche Zwecke, insbesondere zur Wärmeableitung verwendet werden.

Verbundkörper nach der Erfindung können mit Vorteil zur passiven Wärmeableitung verwendet werden. Infolge der hohen Wärmeleitfähigkeit können bezüglich der Wärmeableitung oder Temperatursenkung einer Energiequelle, die auf die Oberfläche der Diamantschicht des erfindungsgemäßen Verbundkörpers direkt aufgebracht ist, Verbesserungen erzielt werden. Dabei ist es von Vorteil, wenn der Hitze oder Kälte erzeugende Körper, d.h. die Energiequelle, kleiner als die Diamantschicht ist. Wärme oder Kälte, die über Strahlung oder durch Konvektion von Gasen, Flüssigkeiten oder Festkörpern an die Diamantschicht übertragen werden oder beim Auftreffen von beschleunigten Partikeln, Molekülen, Radikalen, Atomen, Ionen, Elektronen usw. an der Oberfläche der Diamantschicht direkt entstehen, können In analoger Weise abgeführt werden, wodurch die an der Diamantoberfläche auftretende Temperatur bei gleicher Energiezufuhr niedriger bleibt als die der Körper ohne diese Schicht haben würde.

Daraus ergibt sich eine Reihe von Anwendungen erfindungsgemäßer Verbundkörper als Oberflächen, die im Betrieb erwärmt oder gekühlt werden müssen, z.B. als sogenannte Wärmesenken, wie sie industriell für Halbleiter verwendet werden, oder zur Wärmeableitung aus Körpern, wie fokusierenden Infrarotlinsen oder Oberflächen von mechanischen, elektrischen oder elektronischen Bauteilen.

Wenn die Wärmequelle, von der die Wärme mit Hilfe des Verbundkörpers nach der Erfindung abgeführt werden soll, kleiner als die Niederdruckdiamantschicht ist, auf der die Wärmequelle sitzt, entsteht nicht nur ein Wärmefluß quer durch die Diamantschicht, sondern zusätzlich ein Wärmefluß in der Schichtebene, so daß sich die Wärme schnell im gesamten Verbundkörper verteilt und eine zusätzlich verbesserte Wärmeabführung resultiert.

Die erfindungsgemäßen Verbundkörper können auch für Anwendungen mit einer zusätzlichen aktiven Funktion der Oberfläche des Verbundkörpers eingesetzt werden, wobei neben der verbesserten Wärmeleitfähigkeit auch andere Eigenschaften des Diamants genutzt werden.

Beispielsweise kann durch direkte Reibung der Diamantschicht mit einem Körper unter hohen Geschwindigkeiten und hohem lokalen Druck an seiner Oberfläche Wärme entstehen. Die große Härte des Diamants, seine hohe chemische Resistenz und andere vorteilhafte Eigenschaften würden durch starke Erwärmung verschlechtert, und seine Neigung zur Graphitbildung würde stark zunehmen. Solche Verhältnisse können beispielsweise bei der spanabhebenden Bearbeitung in Werkzeugen oder bei anderen, dem Verschleiß unterworfenen Bearbeitungs- und Gleitvorgängen auftreten. Durch die gute Wärmeableitung der erfindungsgemäßen Verbundkörper wird die Verschlechterung der sonstigen Eigenschaften des Diamants vermieden. Die Senkung der Oberflächentemperatur des Diamants verzögert chemische und physikalische Reaktionen, wie Graphitumwandlung, Oxidation und Kohlenstoffdiffusion, und führt damit zu geringeren Verlusten und Beschädigungen durch Verschleiß, Korrosion, Oberflächenrauhigkeiten, Ausbrechen usw. Damit wird die Lebensdauer von Werkzeugen oder Bauteilen mit Diamantschichten erhöht, wenn diese Diamantschichten erfindungsgemäß mit dem Kohlenstoffisotop $C^{12}$ angereichert sind.

Wenn die Wärmeentstehung in punktförmigen, winzigen Mikrobereichen erfolgt, wie dies z.B. bei vielen Verschleißvorgängen der Fall ist, kann auch die Fähigkeit zur Wärmeableitung, die auf kleine Flächenbereiche beschränkt ist, den erwünschten Effekt erbringen. Daher kann der Erfindungsgegenstand auch seine Wirksamkeit entfalten, wenn durch viele, durchgehende Stengelkristalle ein polykristalliner Schichtaufbau gegeben ist. Derartige Schichtstrukturen entstehen bei CVD-Verfahren häufig spontan. Jedes einzelne Korn einer derartigen Schicht wirkt dann für sich in Richtung der Stengelkristallachse wie ein Einkristall als wärmeableitendes Element. Dabei ist es zweckmäßig, wenn die Gitterfehler bevorzugt in den Korngrenzen auftreten und die Stengelkristallkörner selbst möglichst fehlerfrei und einkristallin sind.

In ähnlicher Weise wirkt auch ein Monokristall, der bekanntermaßen weniger perfekt als ein Einkristall ist, mit Kleinwinkelkorngrenzen und einheitlicher Kristallorientierung, die bei günstigen Wachstumsverhältnissen des Diamants entstehen. Mit solchen Monokristallen kann vielfach ein ähnlicher Effekt erzielt werden, wie mit einem Einkristall.

Wie oben eingehend ausgeführt wurde, können bei allen diesen Anwendungen zusätzliche Vorteile erzielt werden, wenn man die Oberfläche der Niederdruckdiamantschicht mit $C^{12}$-Anreicherung noch mit einer weiteren Beschichtung versieht, die eine Übertragung von Phononenimpulsen vom und zum Diamantgitter begünstigt und/oder als Schutzschicht gegen die Einleitung chemischer und physikalischer Reaktionen fungiert.

## Beispiel 1

Auf einem Substrat eines Hochdruck-Diamanteinkristalles (z.B. Sumicrystal) wurde bei einer Substratoberflächentemperatur von 1050°C unter Verwendung von mit $C^{12}$ angereichertem Kohlenstoff in einer Mikrowellenapparatur Astex (1,5 kW) eine Niederdruckdiamantschicht abgeschieden. Die Leistung der Apparatur lag bei 1,2 kW, der Gasdruck bei 80 Torr und die Abscheidungsdauer bei 20 Stunden. Die Zusammensetzung des in der Apparatur verwendeten Gases war Wasserstoff mit 0,5 % Methan und 0,02 % Wasserdampf. Während der genannten Abscheidungsdauer entstand eine Diamantschicht mit 15 $\mu$m Dicke.

## Beispiel 2

Auf einem Hochdruckdiamanteinkristall für Wärmesenken (Sumicrystal) wurde bei einer Substratoberflächentemperatur von 950 bis 1050°C während einer Abscheidungsdauer von 48 Stunden nach dem Hot-Filament-Verfahren eine Niederdruckdiamantschicht abgeschieden. Die Apparatur enthielt einen Tantaldraht mit 2100 bzw. 2200°C. Der Abstand zum Substrat war 7/11 mm (Drahtdurchmesser 0,3 mm/1000 Watt) bzw. 25/40 mm (Drahtdurchmesser 2mm/7 kW). Es wurde mit $C^{12}$ angereicherter Kohlenstoff verwendet. Das verwendete Gasgemisch bestand aus Wasserstoff mit 0,8 Mol-% Aceton bzw. 0,4 Mol-% Methanol. Die Abscheidungsdauer lag bei 48 Stunden, wobei eine Diamantschicht mit einer Dicke von 30/45 $\mu$m entstand.

## Beispiel 3

Beispiel 2 wurde wiederholt, wobei jedoch auf der Oberfläche der entstandenen Niederdruckdiamantschicht noch im CVD-Verfahren eine 2 $\mu$m dicke Schicht von TiC bzw. Ti(N, C) bzw. SiC oder nach dem PVD-Verfahren eine 0,5 $\mu$m dicke Schicht dieser Hartstoffe aufgebracht wurde.

## Beispiel 4

Ein Schneidwerkzeug wurde erfindungsgemäß durch eine Diamantzwischenschicht verbessert, wobei das gesamte Schneidwerkzeug als Verbundkörper nach der Erfindung anzusehen ist.

Das Substrat bestand aus einer Wendeschneidplatte auf der Basis von Wolframcarbid/Kobalt bzw. Wolframcarbid/Tantalcarbid/Titancarbid/Kobalt.

Auf dieser Wendeschneidplatte wurde eine dünne Schicht von Titancarbid als Sperrschicht gegen eine Kobaltdiffusion und zur Verbesserung des Wärmeübergangs mit einer Dicke von 4 $\mu$m nach dem üblichen CVD-Verfahren aufgebracht.

Darüber wurde mit den Maßnahmen des Beispiels 1 eine Niederdruckdiamantschicht einer Dicke von 10 $\mu$m im Mikrowellenverfahren aufgebracht. Darüber folgte wieder eine nach dem CVD-Verfahren aufgebrachte 4 $\mu$m dicke Titancarbidschicht zur Erhöhung des Wärmeübergangs und als Oxidationsschutz und als letztes eine 8 $\mu$m dicke $Al_2O_3$-Schicht (CVD-Verfahren) zur Verbesserung der Verschleißfestigkeit.

## Patentansprüche

1. Verbundkörper mit verbesserter Wärmeleitfähigkeit, bestehend aus einem Substrat, dessen Oberflächenschicht ein homöo- oder heteroepitaktisches Wachstum des Diamantgitters aus der Gasphase ermöglicht, und einer auf dem Substrat aufgewachsenen Niederdruckdiamantschicht, dadurch gekennzeichnet, daß die aufgewachsene Diamantschicht gegenüber der normalen Diamantzusammensetzung mit dem Kohlenstoffisotop $C^{12}$ angereichert und den schwereren Kohlenstoffisotopen $C^{13}$ und $C^{14}$ abgereichert ist.

2. Verbundkörper nach Anspruch 1, dadurch gekennzeichnet, daß er von den Kohlenstoffisotopen $C^{13}$ und $C^{14}$ jeweils maximal 0,5 Gew.-% enthält.

3. Verbundkörper nach Anspruch 1 oder 2, dadurch gekennzeichnet, daß er ein einkristallines Substrat oder ein Substrat mit einer einkristallinen Oberflächenschicht besitzt.

4. Verbundkörper nach Anspruch 3, dadurch gekennzeichnet, daß sein einkristallines Substrat bzw. die einkristalline Oberflächenschicht des Substrates aus einem nicht mit dem Kohlenstoffisotop $C^{12}$ angereicherten Diamanteinkristall besteht.

5. Verbundkörper nach Anspruch 4, dadurch gekennzeichnet, daß das einkristalline Substrat bzw. die einkristalline Oberflächenschicht des Substrates aus Diamant mit wenig Verunreinigungen und hoher Wärmeleitfähigkeit besteht.

6. Verbundkörper nach Anspruch 1 oder 2, dadurch gekennzeichnet, daß sein Substrat aus monokristallinem oder stengelkristallinem Diamant besteht oder eine solche Oberflächenschicht besitzt.

7. Verbundkörper nach einem der Ansprüche 1 bis 3, dadurch gekennzeichnet, daß das einkristalline Substrat oder die einkristalline Oberflächenschicht des Substrates aus BN, BP, $C_3N_4$ oder einem Mischkristall, einer ternären Phase oder einem Mischkörper aus einem oder mehreren der Elemente C, B, N, O, P und/oder S besteht.

8. Verbundkörper nach einem der Ansprüche 1 bis 3, dadurch gekennzeichnet, daß die Oberflächenschicht des Substrates aus einer dünnen Schicht von diamantartigem Kohlenstoff, amorphem Diamant oder einem anderen kohlenstoffhaltigen Körper besteht.

9. Verbundkörper nach einem der Ansprüche 1 bis 8, dadurch gekennzeichnet, daß die Niederdruckdiamantschicht auf dem Substrat aus monokristallinem oder stengelkristallinem, vorzugsweise aus einkristallinem Diamant besteht.

10. Verbundkörper nach einem der Ansprüche 1 bis 9, dadurch gekennzeichnet, daß die Niederdruckdiamantschicht das Substrat wenigstens teilweise bedeckt und eine Mindestdicke von 4 $\mu$m hat.

11. Verbundkörper nach einem der Ansprüche 1 bis 10, dadurch gekennzeichnet, daß er auf seiner Oberfläche und/oder unter der mit $C^{12}$ angereicherten Niederdruckdiamantschicht eine zusätzliche Schicht eines anorganischen Stoffes aufweist, der eine Übertragung von Phononenimpulsen vom und zum Diamantgitter begünstigt.

12. Verbundkörper nach Anspruch 11, dadurch gekennzeichnet, daß seine zusätzliche Schicht aus einem anderen Superhartstoff oder aus einem Hartstoff aus der Gruppe der Carbide, Nitride, Boride, Phosphide, Sulfide, Aluminide, Oxide oder deren Mischkristallen oder einer harten intermetallischen Phase besteht.

13. Verbundkörper nach einem der Ansprüche 1 bis 12, dadurch gekennzeichnet, daß er eine zusätzliche Schutzschicht, vorzugsweise aus Titancarbid, Titannitrid, Titancarbonitrid, Titanborid oder Siliciumcarbid aufweist.

14. Verfahren zur Herstellung eines Verbundkörpers nach einem der Ansprüche 1 bis 13 durch Aufwachsen einer Diamantschicht mit Hilfe der Niederdruckdiamantsynthese auf einem Substrat, dadurch gekennzeichnet, daß man während des Aufwachsens der Diamantschicht in der Gasphase ein mit dem Kohlenstoffisotop $C^{12}$ angereichertes und mit den schwereren

Kohlenstoffisotopen $C^{12}$ und $C^{14}$ abgereichertes Gas verwendet.

15. Verfahren nach Anspruch 14, dadurch gekennzeichnet, daß man die Niederdruckdiamantschicht epitaktisch in Form eines Einkristalles aufwächst.

16. Verfahren nach Anspruch 14 oder 15, dadurch gekennzeichnet, daß man als Substrat ein einkristallines Substrat oder ein Substrat mit einer einkristallinen Oberflächenschicht verwendet.

17. Verfahren nach einem der Ansprüche 14 bis 16, dadurch gekennzeichnet, daß man ein Substrat verwendet, das ein heteroepitaktisches Aufwachsen einer einkristallinen Diamantschicht nur teilweise oder gar nicht ermöglicht, dessen Oberflächenschicht aber unter den Bedingungen der Niederdruckdiamantsynthese eine das heteroepitaktische Wachstum des Diamantgitters ermöglichende Kristallorientierung annimmt.

18. Verfahren nach einem der Ansprüche 14 bis 16, dadurch gekennzeichnet, daß man ein Substrat verwendet, das ein heteroepitaktisches Aufwachsen einer einkristallinen Diamantschicht nur teilweise oder gar nicht ermöglicht, dessen Oberflächenschicht aber unter den Bedingungen der Niederdruckdiamantsynthese eine Diamantschicht mit monokristalliner oder stengelkristalliner Struktur entwickelt.

19. Verfahren nach einem der Ansprüche 14 bis 18, dadurch gekennzeichnet, daß man zusätzlich eine Schicht eines anorganischen Stoffes, der eine Übertragung von Phononenimpulsen vom und zum Diamantgitter begünstigt, auf der Oberfläche der aufgewachsenen Niederdruckdiamantschicht und/oder unter derselben nach dem PVD-Verfahren, CVD-Verfahren oder durch Sputtern, aufbringt.

20. Verfahren nach Anspruch 19, dadurch gekennzeichnet, daß man als zusätzliche Schicht einen Superhartstoff oder einen Hartstoff aus der Gruppe der Carbide, Nitride, Boride, Phosphide, Sulfide, Aluminide, Oxide oder deren Mischkristallen oder eine harte intermetallische Phase aufbringt.

21. Verwendung eines Verbundkörpers nach einem der Ansprüche 1 bis 13 zur Wärmeableitung.